# EUROPÄISCHE PATENTANMELDUNG

(11) **EP 0 868 020 A1**
(43) Veröffentlichungstag der Anmeldung: **30.09.1998**
(21) Anmeldenummer: 98200511.8
(22) Anmeldetag: 18.02.1998
(51) Int. Cl.: H03D 3/24, H04N 7/46

(54) **Ton-FM-Demodulator für TV-Signale und Verfahren zur Tonträgererkennung**

(30) Priorität: 28.02.1997 DE 19708059
(71) Anmelder: Philips Patentverwaltung GmbH, 22335 Hamburg (DE); Koninklijke Philips Electronics N.V., 5621 BA Eindhoven (NL)
(72) Erfinder: Heinke, Burkhard, Röntgenstrasse 24, 22335 Hamburg (DE)
(74) Vertreter: von Laue, Hanns-Ulrich, Dipl.-Ing.

(57) **Zusammenfassung**

Für einen FM-Demodulator zur Demodulation von Ton-FM-Signalen ist zum möglichst einfachen Aufbau und zur Vermeidung von Keramikfiltern vorgesehen, daß dieser einen steuerbaren Verstärker aufweist, dem die auf Zwischenfrequenzen umgesetzten Tonsignale zugeführt werden, dessen Verstärkung mittels einer Amplituden-Regelschaltung (4) eingestellt wird und dessen Ausgangssignal dem Phasenregelkreis, der ausgangsseitig im eingerasteten Zustand ein demoduliertes Tonsignal liefert, und der Amplituden-Regelschaltung zugeführt wird, daß in dem Phasenregelkreis ein Schleifenfilter (7), das ein Filter (8,9,10) wenigstens zweiter Ordnung mit einer Polstelle bei der Frequenz f=0 aufweist, und eine Grenzen-Erkennungsschaltung (13) vorgesehen sind, welche die Arbeitsfrequenz des Phasenregelkreises, wenn diese einen vorgegebenen Frequenzbereich um eine vorgebbare Soll-Demodulationsfrequenz herum verläßt, in diesen Frequenzbereich zurücksteuert und daß die Amplituden-Regelschaltung (4) den steuerbaren Verstärker (1) in Abhängigkeit von dessen Ausgangssignal und eines von der Frequenz des Ausgangssignals eines in dem Phasenregelkreis vorgesehenen spannungsgesteuerten Oszillators (14) abhängigen Signals so steuert, daß die Ausgangssignale des steuerbaren Verstärkers (1) eine Soll-Amplitude aufweisen.

## Beschreibung

Die Erfindung betrifft einen FM-Demodulator zur Demodulation von FM-Ton-Signalen eines Bildsignals, vorzugsweise eines ZF-Bildsignals, mit einem Phasenregelkreis, sowie ein Verfahren zur Detektion von FM-Tonträgern mittels eines derartigen FM-Demodulators.

In Bildsignalen ist im allgemeinen wenigstens ein Tonsignal enthalten, welches frequenzmoduliert ist. In den verschiedenen Fernsehnormen ist jedoch der Frequenzabstand zwischen der Trägerfrequenz des Bildträgers und der Trägerfrequenz des oder der Tonträger verschieden gewählt. Ein Ton-FM-Demodulator für derartige Signale muß sich daher auf verschiedene Frequenzen für den FM-Tonträger abstimmen lassen. Auch für ein bereits auf die Zwischenfrequenzebene umgesetztes Bildsignal gilt für die Demodulation der Tonsignale nichts anderes.

Bekannte FM-Demodulatoren für FM-Tonsignale eines Bildsignals arbeiten mit einem Begrenzer-Verstärker, dem eine PLL nachgeschaltet ist. Infolge des Begrenzers am Eingang der Schaltungsanordnung hat die gesamte Anordnung jedoch keine Selektivität. Es sind zur Ausfilterung der FM-Tonträger Keramikfilter erforderlich. Diese Keramikfilter erfordern einerseits einen relativ hohen schaltungstechnischen Aufwand und sind nicht in integrierten Schaltkreisen zu realisieren. Zum anderen ist für jede mögliche FM-Tonträgerfrequenz ein eigenes Keramikfilter erforderlich. Eine derartige Schaltungsanordnung ist beispielsweise aus dem PHILIPS-IC TDA 9820 plus externer Verschaltung bekannt.

Es ist Aufgabe der Erfindung, einen FM-Demodulator anzugeben, welcher bei einer möglichst einfachen und integrierbaren Schaltung ohne Kermaikfilter auskommt und welcher auch zur Erkennung von FM-Tonträgern einsetzbar ist.

Diese Aufgabe ist erfindungsgemäß dadurch gelöst, daß ein steuerbarer Verstärker vorgesehen ist, dem die auf Zwischenfrequenzen umgesetzten Tonsignale zugeführt werden, dessen Verstärkung mittels einer Amplituden-Regelschaltung eingestellt wird und dessen Ausgangssignal dem Phasenregelkreis, der ausgangsseitig im eingerasteten Zustand ein demoduliertes Tonsignal liefert, und der Amplituden-Regelschaltung zugeführt wird, daß in dem Phasenregelkreis ein Schleifenfilter, das ein Filter wenigstens zweiter Ordnung mit einer Polstelle bei der Frequenz f=0 aufweist, und eine Grenzen-Erkennungsschaltung vorgesehen sind, welche die Arbeitsfrequenz des Phasenregelkreises, wenn diese einen vorgegebenen Frequenzbereich um eine vorgebbare Soll-Demodulationsfrequenz herum verläßt, in diesen Frequenzbereich zurücksteuert und daß die Amplituden-Regelschaltung den steuerbaren Verstärker in Abhängigkeit von dessen Ausgangssignal und eines von der Frequenz des Ausgangssignals eines in dem Phasenregelkreis vorgesehenen spannungsgesteuerten Oszillators abhängigen Signals so steuert, daß die Ausgangssignale des steuerbaren Verstärkers eine Soll-Amplitude aufweisen.

In der erfindungsgemäßen Schaltungsanordnung ist ein steuerbarer Verstärker vorgesehen, welcher mittels einer Amplituden-Regelschaltung so gesteuert wird, daß dessen Ausgangssignale eine Soll-Amplitude aufweisen. Es handelt sich dabei nur um eine Verstärkungsregelung, nicht um eine Begrenzung der Signale, die dem steuerbaren Verstärker zugeführt werden. Dem steuerbaren Verstärker ist ein Phasenregelkreis nachgeschaltet, welcher ein Schleifenfilter aufweist, das ein Filter wenigstens zweiter Ordnung beinhaltet. Dieses Filter weist eine Polstelle bei der Frequenz Null auf und hat damit eine theoretisch unendlich hohe Gleichspannungs-bzw. Gleichstromverstärkung.

Im Gegensatz zu dem Stande der Technik handelt es sich bei diesem Phasenregelkreis um einen Phasenregelkreis mit eigener Selektivität, der linear arbeitet. Die Bandbreite des Phasenregelkreises ist abhängig von der Amplitude des Eingangssignals, die mittels des steuerbaren Verstärkers und der Amplitudenregelschaltung auf einen gewünschten Wert geregelt wird. Damit ist der Phasenregelkreis im Gegensatz zu der Schaltungsanordnung nach dem Stande der Technik in der Lage, einen bestimmten FM-Tonträger mit einer bestimmten Frequenz auszufiltern und auf diesen einzurasten, d.h. die Frequenz des Phasenregelkreises mit dessen Frequenz zu synchronisieren.

Da nicht immer bekannt ist, welches Fernsehsystem mit Bildsignal und FM-Tonträger empfangen wird, dessen FM-Tonträger demoduliert werden soll, ist zusätzlich eine Grenzen-Erkennungsschaltung vorgesehen, welche signalisiert, wenn die Arbeitsfrequenz des Phasenregelkreises, also diejenige Frequenz, auf die der Phasenregelkreis eingerastet ist, einen vorgebbaren Frequenzbereich um die eingestellte FM-Tonträgerfrequenz, also die Soll-Demodulationsfrequenz, herum verläßt. Damit ist eine Erkennung dahingehend möglich, daß ein FM-Tonträger der eingestellten Soll-Demodulationsfrequenz tatsächlich nicht vorliegt. Dies ist möglich, da in dem Falle, daß ein FM-Tonträger der in der Grenzen-Erkennungsschaltung eingestellten Soll-Demodulationsfrequenz tatsächlich vorliegt, die PLL auf diesem einrastet und die Arbeitsfrequenz des Phasenregelkreises im Frequenzbereich um diese Soll-Demodulationsfrequenz herum nicht verläßt. Nur wenn ein solcher Tonträger mit der vorgegebenen Soll-Demodulationsfrequenz nicht vorliegt, "wandert" die Arbeitsfrequenz des Phasenregelkreises aus dem vorgegebenen Frequenzbereich heraus. Dies erkennt die Grenzen-Erkennungsschaltung, deren Signal zur systematischen FM-Tonträgererkennung eingesetzt werden kann.

Gemäß einer Ausgestaltung der Erfindung ist vorgesehen, daß zwei Stromquellen, welche Ströme unterschiedlichen Vorzeichens und unterschiedlicher Größe in das Schleifenfilter einspeisen können, vorgesehen sind und daß die Grenzen-Erkennungsschaltung in dem Fall, daß die Arbeitsfrequenz des Phasenregelkreises den vorgegebenen Frequenzbereich um die Soll-Demodulationsfrequenz herum verläßt, die Stromquellen so steuert, daß die Arbeitsfrequenz des Phasenregelkreises wieder in den vorgegebenen Frequenzbereich um die Soll-Demodulationsfrequenz herum zurückgesteuert wird.

Um die Störsicherheit der erfindungsgemäßen Schaltung zu erhöhen, kann es sinnvoll sein, eine einmalige Überschreitung der Grenzen des vorgegebenen Frequenzbereiches noch nicht auszuwerten, sondern zu versuchen, die Arbeitsfrequenz des Phasenregelkreises in dem vorgegebenen Frequenzbereich zu halten. Hierzu ist es vorteilhaft, daß die Grenzen-Erkennungsschaltung in dem Fall, daß eine Grenzen des Frequnzbereiches um die Soll-Demodulationsfrequenz herum verlassen wird, mittels der Stromquellen derartige Stromimpulse in das Filter des Schleifenfilters einspeist, daß in dem Phasenregelkreis vorgesehene spannungsgesteuerte Oszillator wieder in einem Frequenzbereich arbeitet, der in dem vorgegebenen Frequenzbereich liegt. Damit wird der Phasenregelkreis quasi gewaltsam wieder in diesen Frequenzbereich zurückgesteuert. Dieser Vorgang kann gegebenenfalls mehrfach wiederholt werden. Sollte auch nach mehrfachem Zurücksteuern der Arbeitsfrequenz des Phasenregelkreises in den vorgegebenen Frequenzbereich erfolglos bleiben, kann mit erhöhter Sicherheit davon ausgegangen werden, daß in dem vorgegebenen Frequenzbereich kein FM-Tonträger vorliegt.

Gemäß einer weiteren Ausgestaltung der Erfindung ist vorgesehen, daß in der Grenzen-Erkennungsschaltung ein setzbarer Zähler, welcher zu Beginn eines Meßzyklus auf einen von der Soll-Demodulationsfrequenz abhängigen Anfangswert gesetzt wird und welcher während des Meßzyklus in Abhängigkeit des Phasenregelkreis-Signals weiterzählt, und eine Auswerte-Logik vorgesehen sind, die nach Ablauf des Meßzyklus in Abhängigkeit des erreichten Zählerstandes des Zählers die Stromquellen ansteuert.

Die Erkennung der Arbeitsfrequenz des Oszillators des Phasenregelkreises kann auf diese Weise einfach mittels eines Zählers vorgenommen werden. Der Zähler wird zu Beginn eines Meßzyklus auf einen definierten Anfangswert gesetzt, der von der Soll-Demodulationsfrequenz abhängig ist. Während des Meßzyklus zählt der Zähler in Abhängigkeit des Schwingsignals des Oszillators des Phasenregelkreises weiter. Am Ende des Meßzyklus, der eine definierte Länge aufweist, wertet eine Auswerte-Logik den dann erreichten Zählerstand aus. Dieser Zählerstand ist ein unmittelbares Maß dafür, inwieweit die Schwingfrequenz des spannungsgesteuerten Oszillators des Phasenregelkreises von der Soll-Demodulationsfrequenz abweicht. Da der Anfangszählerstand in Abhängikeit der Soll-Demodulationsfrequenz gewählt wird, erreicht der Zähler am Ende des Meßzyklus dann, wenn diese Soll-Demodulationsfrequenz tatsächlich vorliegt, einen bestimmten Soll-Zählerstand. Ist die Arbeitsfrequenz des Phasenregelkreises tatsächlich höher, wird dieser Soll-Zählerstand überschritten, ist sie niedriger, wird er unterschritten. Aus diesen Abweichungen kann unmittelbar Rückschluß auf die Arbeitsfrequenz des Phasenregelkreises gezogen werden.

Auf diese Weise ist eine äußerst einfache Erkennung der Arbeitsfrequenz des Phasenregelkreises möglich.

Eine weitere Ausgestaltung der Erfindung sieht vor, daß die Auswerte-Logik in dem Fall, daß der Zählerstand nach Ablauf des Meßzyklus einen vorgegebenen unteren Grenzwert unterschreitet, während einer vorgegebenen Zeitspanne diejenige Stromquelle aktiviert, welche einen positiven Stromimpuls in das Schleifenfilter einspeist, und daß die Auswerte-Logik in dem Fall, daß der Zählerstand nach Ablauf des Meßzyklus einen vorgegebenen oberen Grenzwert überschreitet, während einer vorgegebenen Zeitspanne diejenige Stromquelle aktiviert, welche einen negativen Stromimpuls in das Schleifenfilter einspeist.

Da, wie oben erläutert, der Zählerstand nach Ablauf des Meßzyklus indiziert, inwieweit die Arbeitsfrequenz des Phasenregelkreises von der Soll-Demodulationsfrequenz abweicht, kann der Zählerstand dazu herangezogen werden, die Arbeitsfrequenz des Phasenregelkreises wieder in den vorgegebenen Frequenzbereich um die Soll-Demodulationsfrequenz zurückzusteuern.

Dies kann mittels der oben erläuterten Stromquellen geschehen, welche in Abhängigkeit des Vorzeichens der Abweichung der Arbeitsfrequenz von der Soll-Demodulationsfrequenz einen positiven oder einen negativen Stromimpuls in das Schleifenfilter einspeisen, wodurch unmittelbar eine Rücksteuerung der Arbeitsfrequenz des Phasenregelkreises in den vorgegebenen Frequenzbereich erfolgt.

Dies kann dann sinnvoll sein, wenn über mehrere Meßzyklen hinweg verfolgt werden soll, ob eine Soll-Demodulationsfrequenz erkennt wird. Wie oben bereits erläutert, ist diese Nachsteuerung dann nicht erforderlich, wenn tatsächlich ein FM-Tonträger auf oder nahe bei der vorgewählten Soll-Demodulationsfrequenz vorliegt, da dann der Phasenregelkreis auf diesem Träger einrastet und den vorgegebenen Frequenzbereich um die Soll-Demodulationsfrequenz herum nicht verläßt.

Erfindungsgemäß ist ferner für ein Verfahren zur Detektion von FM-Tonträgern verschiedener FM-Trägerfrequenzen, welche in einem Bildsignal mit FM-Tonträger, vorzugsweise einem ZF-Bildsignal, enthalten sind, unter Einsatz des erfindungsgemäßen FM-Demodulators vorgesehen, daß eine Steuerung des FM-Demodulators zur Erkennung eines FM-Tonträgers auf einer Soll-Demodulationsfrequenz in der Weise vorgenommen wird, daß in dem Fall, daß die Grenzen-Erkennungsschaltung erkennt, daß die Arbeitsfrequenz der Phasenregelschaltung den vorgegebenen Frequenzbereich um die Soll-Demodulationsfrequenz herum nicht verläßt, ein FM-Tonträger auf der Soll-Demodulationsfrequenz erkannt wird und daß in dem Fall, daß die Grenzen-Erkennungsschaltung erkennt, daß die Arbeitsfrequenz der Phasenregelschaltung den vorgegebenen Frequenzbereich um die Soll-Demodulationsfrequenz herum verläßt, eine andere Soll-Demodulationsfrequenz gewählt wird, für die der Erkennungsvorgang wiederholt wird.

Gemäß dieses Verfahrens wird ausgewertet, ob die Grenzen-Erkennungsschaltung erkennt, daß die Phasenregelschaltung den vorgegebenen Frequenzbereich um die Soll-Demodulationsfrequenz herum verläßt. Wie oben erläutert, kann der erfindungsgemäße FM-Demodulator bzw. dessen Grenzen-Erkennungsschaltung unmittelbar ein Signal abgeben, das dieses signalisiert. Für das erfindungsgemäße Verfahren zur Erkennung eines FM-Tonträgers bedeutet dies, daß der erfindungsgemäße FM-Demodulator bzw. dessen Grenzen-Erkennungsschaltung zunächst auf eine Soll-Demodulationsfrequenz eingestellt wird, auf der ein FM-Tonträger vermutet wird. Die Grenzen-Erkennungsschaltung des FM-Demodulators erkennt nachfolgend, ob der Phasenregelkreis des FM-Demodulators auf einen derartigen Tonträger in dem vorgegebenen Frequenzbereich um diese Soll-Demodulationsfrequenz herum einrastet. Aus diesem Signal wird abgeleitet, ob ein FM-Tonträger tatsächlich vorliegt.

Wird auf der Soll-Demodulationsfrequenz ein FM-Tonträger erkannt, so wird die eingestellte Soll-Demodulationsfrequenz nicht verändert, und der FM-Demodulator liefert ausgangsseitig das demodulierte Tonsignal zur weiteren Verarbeitung. Wird ein solches FM-Tonsignal jedoch nicht erkannt, wird der FM-Demodulator auf eine andere Soll-Demodulationsfrequenz eingestellt, auf der ein FM-Tonträger vermutet wird. Dieser Vorgang wird so lange wiederholt, bis ein FM-Tonträger erkannt wurde.

Die Steuerung des FM-Demodulators gemäß dieses Verfahrens gestattet es, auf einfache Weise eine Erkennung der Fernsehnorm des empfangenen Bildsignals vorzunehmen. Aus der erkannten FM-Tonträgerfrequenz kann nämlich unmittelbar ein Rückschluß auf die Fernsehnorm vorgenommen werden, da für verschiedene Fernsehnormen verschiedene FM-Tonträgerfrequenzen vorgesehen sind.

Gemäß einer weiteren Ausgestaltung der Erfindung ist vorgesehen, daß eine vorgegebene Anzahl, vorzugsweise zehn, von Meßzyklen ohne Auswertung der Ergebnisse durchfahren wird, bevor der maßgebliche Erkennungsmeßzyklus erfolgt, dessen Ergebnis ausgewertet wird.

Ein Durchfahren von zehn Meßzyklen in dieser Weise erhöht die Erkennungssicherheit. Es wird auf diese Weise sichergestellt, daß z.B. nicht eine einmalige Störung den Phasenregelkreis veranlaßt, den vorgegebenen Frequenzbereich um die Soll-Demodulationsfrequenz herum zu verlassen.

Gemäß einer weiteren Ausgestaltung des erfindungsgemäßen Verfahrens ist vorgesehen, daß eine Erkennung eines Tonträgers nur dann erfolgt, wenn der Meßzyklus eine Erkennung eines Tonträgers ergibt und die Amplitude des Eingangssignals des steuerbaren Verstärkers in einem Soll-Amplitudenbereich liegt.

Die Erkennungssicherheit kann durch die Auswertung der Amplitude des Eingangssignals des steuerbaren Verstärkers und damit des eingestellten Verstärkungsfaktors des steuerbaren Verstärkers erfolgen, da bekannt ist, welche Amplitude ein FM-Tonträger am Eingang des steuerbaren Verstärkers etwa aufweisen muß. Liegt ein Signal dieser Amplitude nicht vor, so kann auch daraus der Rückschluß gezogen werden, daß auf der Soll-Demodulationsfrequenz ein FM-Tonträger tatsächlich nicht vorliegt. Die Kombination der Auswertung der Signale des FM-Demodulators in der oben beschriebenen Weise und der eingestellten Verstärkung des Verstärkers erhöht damit die Erkennungssicherheit.

Nachfolgend werden der erfindungsgemäße FM-Demodulator sowie das erfindungsgemäße Verfahren zur Erkennung von FM-Tonträgern anhand der Zeichnung näher erläutert. Es zeigen:
Fig. 1 einen erfindungsgemäßen FM-Demodulator als Blockschaltbild,
Fig. 2 ein Blockschaltbild der Grenzen-Erkennungsschaltung des FM-Demodulators gemäß Fig. 1,
Fig. 3 eine schematische Darstellung des Zählstandes des Zählers der Grenzen-Erkennungsschaltung gemäß Fig. 1 und
Fig. 4 den zeitlichen Verlauf des Spannungsabfalles über dem Filter des Schleifenfilters des FM-Demodulators gemäß Fig. 1.

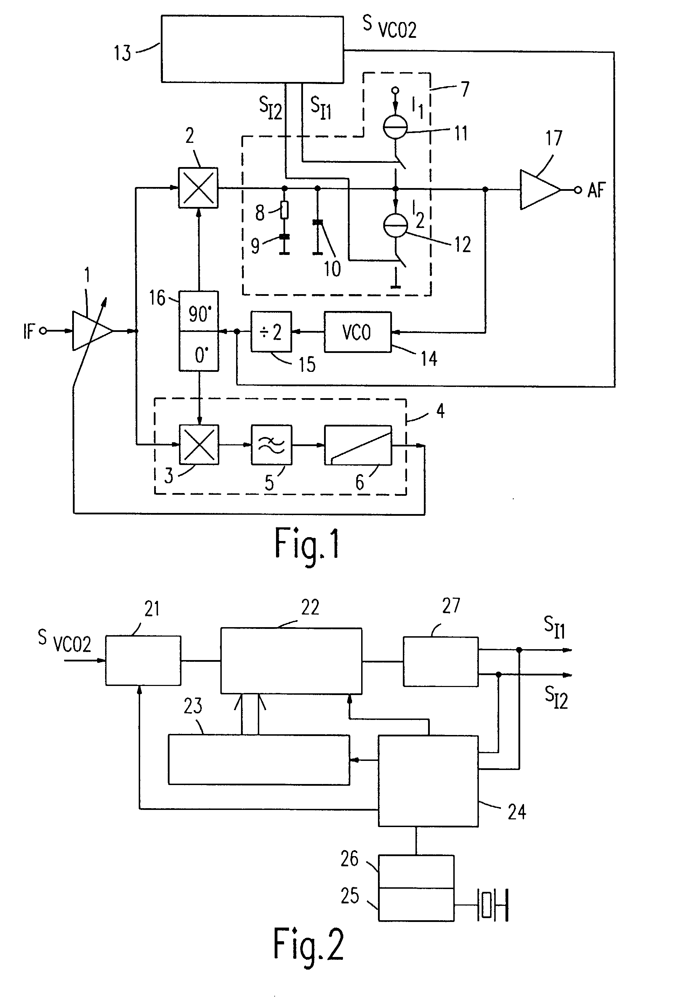

Ein in Fig. 1 dargestelltes Blockschaltbild zeigt den erfindungsgemäßen FM-Demodulator, dem eingangsseitig ein Zwischenfrequenz-Bildsignal zugeführt wird, das in der Figur mit IF gekennzeichent ist. Dieses Signal enthält auch ein FM-Tonsignal. Der FM-Demodulator soll dieses Signal sowohl ausfiltern wie auch demodulieren.

Das ZF-Bildsignal, das den FM-Tonträger enthält, wird eingangsseitig einem steuerbaren Verstärker 1 zugeführt, dessen Ausgangssignal auf einen ersten Mischer 2 eines Phasenregelkreises und einen zweiten Mischer 3 einer Amplituden-Regelschaltung 4 zugeführt wird.

Dem zweiten Mischer 3 der Amplituden-Regelschaltung 4 sind ein Tiefpaßfilter 5 ein PI-Regler 6 nachgeschaltet. Das Ausgangssignal des PI-Reglers 6 stellt auch das Ausgangssignal der Amplituden-Regelschaltung dar. Der PI-Regler 6 nimmt einen Soll-Ist-Vergleich des ihm zugeführten Signals vor und liefert ausgangsseitig ein Stellsignal an den steuerbaren Verstärker 1, dessen Verstärkung so eingestellt wird, daß die Ausgangsamplitude des steuerbaren Verstärkers 1 einen vorgegebenen Soll-Wert aufweist.

In dem Phasenregelkreis des FM-Demodulators ist dem ersten Mischer 2 ein Schleifenfilter 7 nachgeschaltet, welches ein Filter zweiter Ordnung aufweist. Dieses Filter weist eine Polstelle bei der Frequenz Null auf und hat damit eine unendlich hohe Gleichspannungs- bzw. Gleichstromverstärkung. Das Filter zweiter Ordnung ist mittels eines Widerstandes 8 und einer Kapazität 9 aufgebaut, welche vom Ausgang des zweiten Mischers gegen ein Bezugspotential geschaltet sind. Parallel zu diesen ist ferner eine zweite Kapazität 10 gegen dieses Bezugspotential geschaltet. In dieses Filter kann mittels einer ersten Stromquelle 11 ein positiver Stromimpuls oder mittels einer zweiten Stromquelle 12 ein negativer Stromimpuls eingespeist werden. Die beiden Stromquellen 11 bzw. 12 werden von einer Grenzen-Erkennungsschaltung 13 angesteuert, welche entsprechende Schaltsignale S_{I1} oder S_{I2} zur Ansteuerung der Stromquellen 11 bzw. 12 liefert.

Innerhalb des Phasenregelkreises ist dem Schleifenfilter 7 ein spannungsgesteuerter Oszillator 14 nachgeschaltet. Das Ausgangssignal dieses spannungsgesteuerten Oszillators gelangt über einen Teiler 15 an einen Phasenschieber 16, der das Signal ohne Phasenverschiebung an den zweiten Mischer 3 der Amplituden-Regelschaltung 4 und mit einer Phasenverschiebung von 90° an den ersten Mischer 2 des Phasenregelkreises liefert.

Das Ausgangssignal des Teilers 15 ist außerdem der Grenzen-Erkennungsschaltung 13 zugeführt.

Hinter dem Schleifenfilter 7 wird das Schwingsignal des FM-Demodulators abgegriffen und mittels eines Verstärkers 17 verstärkt, der ausgangsseitig das demodulierte Tonsignal liefert, das in der Figur mit AF gekennzeichnet ist.

Die in Fig. 1 lediglich in Form eines Blockes dargestellte Grenzen-Erkennungsschaltung 13 ist in Fig. 2 näher in Form eines Blockschaltbildes dargestellt.

Der Grenzen-Erkennungsschaltung gemäß Fig. 2 wird eingangsseitig das Ausgangssignal des Teilers 15 der Anordnung gemäß Fig. 1 zugeführt. Dieses als S_{VCO2} gekennzeichnete Signal gelangt innerhalb der Grenzen-Erkennungsschaltung gemäß Fig. 2 zunächst an eine Synchronisierschaltung 21, welche das Signal S_{VCO2} mit einem Meßfenstersignal aus einer Auswerte-Logik 24 synchronisiert, um ein zeitlich genau bestimmtes Zeifenster zu garantieren. Hierzu wird ein in der Figur nicht dargestelltes D-FlipFlop verwendet, welches vermeidet, daß das Meßfenster zwischen zwei Impulsen des S_{VCO2} -Signals beendet wird.

Der Synchronisierschaltung 21 ist ein Zähler 22 nachgeschaltet, der mittels einer Zählersetz-Anordnung 23 auf einen definierten Zählstand gesetzt werden kann. Sowohl die Zählersetz-Anordnung 23 wie auch der Zähler 22 werden mittels einer Auswerte-Logik gesteuert. Dem Zähler 22 ist eine Fenster-Logik 27 nachgeschaltet, welche eine Auswertung des Zählerstandes vornimmt und welche die Steuersignale S_{I1} und S_{I2} an die Stromquellen 11 und 12 des FM-Demodulators gemäß Fig. 1 liefert. Diese Signale werden innerhalb der Grenzen-Erkennungsschaltung gemäß Fig. 2 auch der Auswerte-Logik 24 zugeführt.

Die Auswerte-Logik 24 wird von einem Taktgenerator 25 gesteuert, dem gegegebenenfalls ein Teiler 26 nachgeschaltet sein kann.

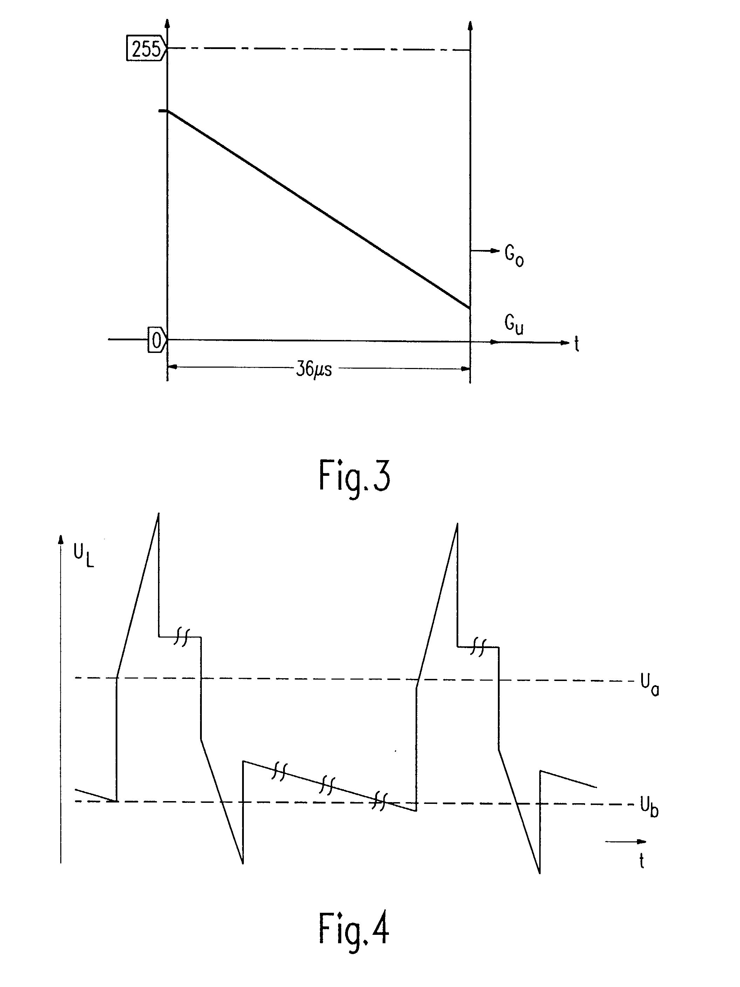

Die Arbeitsweise des FM-Demodulators gemäß Fig. 1 und die in diesem vorgesehene Grenzen-Erkennungsschaltung gemäß Fig. 2 wird im folgenden unter zusätzlicher Heranziehung der schematischen Darstellungen gemäß Fig. 3 und Fig. 4 vorgenommen.

Der FM-Demodulator gemäß Fig. 1 arbeitet linear, da in dem steuerbaren Verstärker 1 keine Begrenzung vorgenommen wird. Er weist damit eine eigene Selektivität auf und benötigt keine Keramikfilter zur Ausfilterung bestimmter FM-Tonträger. Mittels der Amplituden-Regelschaltung wird die Amplitude am Ausgang des steuerbaren Verstärkers 1 auf eine vorgegebene Soll-Amplitude geregelt.

Der Phasenregelkreis mit dem Mischer 2, dem Schleifenfilter 7, dem steuerbaren Oszillator 14, dem Teiler 15 und dem Phasenschieber 16 rastet auf einer Arbeitsfrequenz entsprechend einer eingestellten Soll-Demodulatosfrequenz ein, wenn auf dieser Soll-Demodulationsfrequenz tatsächlich ein FM-Tonträger vorliegt. Dann arbeitet der Phasenregelkreis mit dieser Arbeitsfrequenz.

Liegt auf der Soll-Demodulationsfrequenz hingegen kein FM-Tonträger vor, so wandert die Arbeitsfrequenz infolge der unendlich hohen Gleichspannungsverstärkung, die wegen des Filters zweiter Ordnung in dem Schleifenfilter 7 eintritt, zu seiner oberen oder unteren Frequenzgrenze hin. Dies bedeutet also, daß die Arbeitsfrequenz nach oben oder unten aus einem vorgegebenen Frequenzbereich um die Soll-Demodulationsfrequenz herum hinauswandert. Dies wird mittels der Grenzen-Erkennungsschaltung 13 erkannt.

In der Grenzen-Erkennungsschaltung 13 ist gemäß Fig. 2 ein Zähler 22 vorgesehen. In Abhängigkeit der gewählten Soll-Demodulationsfrequenz wird dieser Zähler zu Beginn eines Meßzyklus mittels der Auswerte-Logik 24 und der Zählersetz-Anordnung 23 auf einen Anfangswert gesetzt. Die Höhe dieses Anfangswertes ist abhängig von der Höhe der Soll-Demodulationsfrequenz. Die Auswerte-Logik der Anordnung gemäß Fig. 2 steuert nachfolgend einen Meßzyklus in der Weise, daß der Zähler 22 in Abhängigkeit des ihm zugeführten Signals S_{VCO2} während des Meßzyklus weiterzählt. Am Ende des Meßzyklus wird der dann erreichte Zählerstand ausgewertet. Dessen Höhe hängt von der Arbeitsfrequenz des Phasenregelkreises des FM-Demodulators gemäß Fig. 1 ab.

Liegt auf der gewählten Soll-Demodulationsfrequenz tatsächlich ein FM-Tonträger vor, so rastet der Phasenregelkreis auf diese Frequenz ein. Eine entsprechende Frequenz liefert das Signal S_{VCO2} an den Zähler 22, der in Abhängigkeit dieses Signals weiterzählt. Hat der Phasenregelkreis eingerastet, so erreicht der Zählerstand des Zählers 22 am Ende des Meßzyklus einen definierten Endwert. Die Auswerte-Logik 24 erkennt dann, daß dieser Zählerstand erreicht wurde, daß also ein oberer Grenzwert des Zählerstandes nicht überschritten und ein unterer Grenzwert des Zählerstandes des Zählers 22 nicht unterschritten wurde. Infolge dessen liefert die Fenster-Logik 27 kein Steuersignal S_{I1} oder S_{I2} an die Stromquellen. Die Schaltung arbeitet stabil; der Phasenregelkreis hat auf die Soll-Demodulationsfrequenz eingerastet, und eine Nachsteuerung durch die Grenzen-Erkennungsschaltung ist nicht erforderlich.

Existiert jedoch auf der Soll-Demodulationsfrequenz tatsächlich kein FM-Tonträger, so wandert die Arbeitsfrequenz des Phasenregelkreises des FM-Demodulators gemäß Fig. 1 infolge der unendlich hohen Gleichspannungsverstärkung des Schleifenfilters zu der oberen oder unteren Grenzfrequenz des Phasenregelkreises. Für die Grenzen-Erkennungsschaltung gemäß Fig. 2 bedeutet dies, daß die Frequenz S_{VCO2} nach oben bzw. nach unten wandert und deutlich höhere bzw. niederigere Werte als im eingerasteten Zustand des Phasenregelkreises aufweist. Dies wiederum bedeutet, daß der Zählerstand des Zählers 22 nach einem Meßzyklus einen deutlich höheren bzw. niedrigeren Wert als den Soll-Endwert aufweist. Dies wird mittels der Fenster-Logik 27 erkannt. Liegt der Zählerstand oberhalb des oberen Grenzwertes, so wird mittels des Steuersignals S_{I2} die zweite Stromquelle angesteuert. Liegt der Endwert des Zählerstandes unterhalb des unteren Grenzwertes, wird mittels des Steuersignals S_{I1} die erste Stromquelle des FM-Demodulators gemäß Fig. 1 angesteuert.

Die Tatsache, daß nach einem Meßzyklus durch die Fenster-Erkennungsschaltung 27 eines der beiden Steuersignale S_{I1} oder S_{I2} ausgelöst wird, wird durch die Auswerte-Logik 24 erkannt. Das Auftauchen eines der Signale bedeutet, daß der Phasenregelkreis des FM-Demodultors gemäß Fig. 1 nicht auf seine Soll-Domodulationsfrequenz eingerastet hat.

Dies zeigt bereits, daß mit hoher Wahrscheinlichkeit auf der Soll-Demodulationsfrequenz tatsächlich kein FM-Tonträger vorhanden ist. Zur Erhöhung der Sicherheit dieser Erkennung kann der Meßvorgang durch mehrere nachfolgende Meßzyklen, die in gleicher Weise ablaufen, wiederholt werden. Zeigen beispielsweise zehn Meßzyklen immer das Ergebnis, daß kein FM-Tonträger vorliegt, daß also nach jedem Meßzyklus die Steuersignale S_{I1} oder S_{I2} auftauchen, so ist sicher erkannt worden, daß auf dieser Frequenz kein FM-Tonträger vorliegt. Die Auswerte-Logik 24 kann dann eine neue Soll-Demodulationsfrequenz wählen, auf der ein FM-Tonträger vermutet wird. Sie steuert in entsprechender Weise die Zählersetz-Anordnung 23 an, die den Zähler-Anfangsstand des Zählers 22 auf einen Wert entsprechend dieser neuen Soll-Demodulationsfrequenz setzt. Nachfolgend wiederholt sich dann der oben beschriebene Vorgang für diese neue Soll-Demodulationsfrequenz.

Zur Erkennung eines FM-Tonträgers und damit der vorliegenden Fernsehnorm wird mittels der Auswerte-Logik 24 so oft eine neue Soll-Demodulationsfrequenz und damit eine neue vermutete FM-Tonträgerfrequenz gewählt, bis auf dieser Frequenz tatsächlich ein FM-Tonträger gefunden wird. Ist dann in einem oder vorteilhaft mehreren Meßzyklen tatsächlich erkannt worden, daß ein FM-Tonträger vorliegt, so ist eine Wahl neuer Soll-Demodulationsfrequenzen nicht mehr erforderlich, und der FM-Demodulator gemäß Fig. 1 liefert ausgangsseitig das demodulierte Tonsignal, das zur weiteren Verarbeitung zur Verfügung steht.

In Fig. 3 ist über der Zeit schematisch der laufende Zählerstand des Zählers 22 der Grenzen-Erkennungsschaltung gemäß Fig. 2 während eines Meßzyklus aufgetragen.

In dem Beispielsfall gemäß Fig. 3 beträgt die Länge des Meßzyklus 36µs. Zu Beginn des Meßzyklus wird der Zähler auf einen Zählerstand geladen, dessen Höhe von der gewählten Soll-Demodulationsfrequenz abhängt. Während des Meßzyklus zählt der Zähler herunter, so daß sich sein Zählerstand gemäß der Darstellung gemäß Fig. 3 ständig verringert. Am Ende des Meßzyklus erreicht der Zähler seinen Endstand. Entspricht der Zählerstand dem Sollwert, so ist der Phasenregelkreis auf die Soll-Demodulationsfrequenz eingerastet. Dieser Fall ist in Fig. 3 dargestellt.

Liegt tatsächlich kein FM-Tonträger auf dieser Frequenz vor, so würde der Zählerstand in der Darstellung gemäß Fig. 3 den oberen Grenzwert G_{O} überschreiten oder den unteren Grenzwert G_{U} unterschreiben. Dies würde eintreten, da der Phasenregelkreis infolge der unendlich hohen Verstärkung seines Schleifenfilters zu seiner oberen oder unteren Frequenz hin wandern würde und der Zähler 22 der Grenzen-Erkennungsschaltung gemäß Fig. 2 ein entsprechend hochfrequenztes bzw. niederfrequentes Signal erhalten würde, so daß der Zähler deutlich schneller bzw. deutlich langsamer zählt und dessen Zähler-Endstand am Ende des Meßzyklus den oberen Grenzwert G_{O} über- oder den unteren Grenzwert G_{U} unterschreiten würde.

Bei einem derartigen Über- bzw. Unterschreiten der Grenzwerte liefert die Fenster-Logik 27 der Grenzen-Erkennungsschaltung gemäß Fig. 2 Steuersignale S_{I1} bzw. S_{I2} an die Stromquellen 11 bzw. 12 des Schleifenfilters 7 des FM-Demodulators gemäß Fig. 1.

Die sich in einem derartigen, nichtsynchronisierten Zustand des Phasenregelkreises am Filter des Schleifenfilters 7 des FM-Demodulators gemäß Fig. 1 einstellenden Spannungsverhältnisse sind in Fig. 4 über der Zeit aufgetragen.

Hierbei ist grundsätzlich zu beachten, daß die in Fig. 4 dargestellten Spannungsverhältnisse am Filter des Schleifenfilters 7 unmittelbar proportional der Arbeitsfrequenz des Phasenregelkreises sind, da der spannunsgesteuerte Oszillator 14 die Frequenz seines Ausgangssignales unmittelbar in Abhängigkeit dieser Spannung einstellt.

Zu Beginn des Kurvenverlaufes der Darstellung gemäß Fig. 4 unterschreitet der Zählerstand des Zählers 22 der Grenzen-Erkennungsschaltung 13 den unteren Grenzwert. Dies bedeutet nach der Darstellung gemäß Fig. 3, daß der Zähler-Endwert unterhalb des Wertes G_{U} liegt. Daraufhin steuert die Fenster-Logik 27 die Stromquelle 11 des Schleifenfilters 7 mittels des Steuersignals S_{I1} an. Dies bedeutet, daß sich die Spannung über dem Filter des Schleifenfilters 7, also über der Parallelschaltung aus der zweiten Kapazität 10 einerseits und der Reihenschaltung aus dem Widerstand 8 und der ersten Kapazität 9 andererseits erhöht. Infolge der über dem Widerstand 8 abfallenden Spannung taucht ein Proportionalanteil auf, der in der Darstellung gemäß Fig. 4 dazu führt, daß sich die Spannung vom Wert Uₐ auf den Wert U_{b} erhöht. Über den Kapazitäten 9 und 10 fällt ferner eine Spannung ab, die einen Integralanteil liefert, der zu einer weiteren Erhöhung der Spannung über den Wert U_{b} hinaus führt.

Da die Stromquelle 11 nur kurzzeitig angesteuert wird, fällt nach dem Abschalten der Stromquelle die Spannung wieder ab. Sie erreicht nicht ganz den Wert Uₐ, sondern liegt oberhalb dieses Wertes. Wird nach diesem Abschalten eine erneute Messung innerhalb eines Meßzyklus vorgenommen, so wird erkannt, daß die Arbeitsfrequenz des Phasenregelkreises oberhalb der Soll-Demodulationsfrequenz liegt. Infolge dessen wird mittels der Grenzen-Erkennungsschaltung 13 die zweite Stromquelle S_{I2} angesteuert. In der Darstellung gemäß Fig. 4 führt dies dazu, daß die Spannung zunächst um einen Proportional- und dann einen Integral-Anteil abfällt. Nach Abschalten der zweiten Stromquelle 12 liegt die Spannung wieder innerhalb des Bereiches zwischen Uₐ und U_{b} und damit innerhalb des vorgegebenen Frequenzbereiches um die Soll-Demodulationsfrequenz herum.

Liegt jedoch auf dieser Frequenz nach wie vor kein FM-Tonträger vor, so fällt in diesem Beispielsfalle die Spannung weiter ab, bis der Wert U_{b} unterschritten ist und damit der vorgegebene Frequenzbereich um die Soll-Demodulationsfrequenz nach unten verlassen wurde. Dies wird in der Auswerte-Logik gemäß Fig. 2 durch den erreichten Zähler-Endstand erkannt, und es wird wiederum die erste Stromquelle mittels des Steuersignals S_{I1} angesteuert, so daß sich der zu Beginn des Diagramms gemäß Fig. 4 dargestellte Vorgang wiederholt.

Liegt weiterhin auf der gewählten Soll-Demodulationsfrequenz kein Tonträger vor, würde sich dieser Vorgang unendlich oft wiederholen. Es würden abwechselnd, gegebenenfalls mit Pausen, die beiden Stromquellen 11 bzw. 12 des Phasenregelkreises des FM-Demodulators gemäß Fig. 1 von der Fenster-Logik 27 der Grenzen-Erkennungsschaltung gemäß Fig. 2 angesteuert. In diesem Falle würde jedoch die Auswerte-Logik 24 erkennen, daß beispielsweise innerhalb von zehn Meßzyklen immer wieder eine Ansteuerung der Stromquellen erfolgt, und würde eine neue Soll-Demodulationsfrequenz wählen und in Abhängigkeit deren Wertes dieser Zählersetz-Anordnung 23 veranlassen, einen neuen Zähler-Anfangswert für einen Meßzyklus zu wählen. Für diese neue Soll-Demodulationsfrequenz würde sich der Vorgang weiter wiederholen. Wird auf der Soll-Demodulationsfrequenz ein Tonträger erkannt, kann der Suchvorgang eingestellt werden. Anderenfalls wird eine neue Soll-Demodulationsfrequenz gewählt und der Zähler 22 auf einen entsprechenden Anfangswert gesetzt, für den der Meßvorgang wiederholt wird.

Dieser Meßvorgang wird so oft für neue Soll-Demodulationsfrequenzen wiederholt, bis ein FM-Tonträger gefunden wurde.

## Patentansprüche

1. FM-Demodulator zur Demodulation von FM-Ton-Signalen eines Bildsignals, vorzugsweise eines ZF-Bildsignals, mit einem Phasenregelkreis,
dadurch gekennzeichnet, daß ein steuerbarer Verstärker (1) vorgesehen ist, dem die auf Zwischenfrequenzen umgesetzten Tonsignale zugeführt werden, dessen Verstärkung mittels einer Amplituden-Regelschaltung (4) eingestellt wird und dessen Ausgangssignal dem Phasenregelkreis, der ausgangsseitig im eingerasteten Zustand ein demoduliertes Tonsignal liefert, und der Amplituden-Regelschaltung zugeführt wird, daß in dem Phasenregelkreis ein Schleifenfilter (7), das ein Filter (8,9,10) wenigstens zweiter Ordnung mit einer Polstelle bei der Frequenz f=0 aufweist, und eine Grenzen-Erkennungsschaltung (13) vorgesehen sind, welche die Arbeitsfrequenz des Phasenregelkreises, wenn diese einen vorgegebenen Frequenzbereich um eine vorgebbare Soll-Demodulationsfrequenz herum verläßt, in diesen Frequenzbereich zurücksteuert und daß die Amplituden-Regelschaltung (4) den steuerbaren Verstärker (1) in Abhängigkeit von dessen Ausgangssignal und eines von der Frequenz des Ausgangssignals eines in dem Phasenregelkreis vorgesehenen spannungsgesteuerten Oszillators (14) abhängigen Signals so steuert, daß die Ausgangssignale des steuerbaren Verstärkers (1) eine Soll-Amplitude aufweisen.

2. FM-Demodulator nach Anspruch 1,
dadurch gekennzeichnet, daß zwei Stromquellen (11,12), welche Ströme unterschiedlichen Vorzeichens und unterschiedlicher Größe in das Schleifenfilter (7) einspeisen können, vorgesehen sind und daß die Grenzen-Erkennungsschaltung (13) in dem Fall, daß die Arbeitsfrequenz des Phasenregelkreises den vorgegebenen Frequenzbereich um die Soll-Demodulationsfrequenz herum verläßt, die Stromquellen (11,12) so steuert, daß die Arbeitsfrequenz des Phasenregelkreises wieder in den vorgegebenen Frequenzbereich um die Soll-Demodulationsfrequenz herum zurückgesteuert wird.

3. FM-Demodulator nach den Ansprüchen 1 und 2,
dadurch gekennzeichnet, daß in der Grenzen-Erkennungsschaltung (13) ein setzbarer Zähler (22), welcher zu Beginn eines Meßzyklus auf einen von der Soll-Demodulationsfrequenz abhängigen Anfangswert gesetzt wird und welcher während des Meßzyklus in Abhängigkeit des Phasenregelkreis-Signals weiterzählt, und eine Auswerte-Logik (24) vorgesehen sind, die nach Ablauf des Meßzyklus in Abhängigkeit des erreichten Zählerstandes des Zählers (22) die Stromquellen (11,12) ansteuert.

4. FM-Demodulator nach Anspruch 3,
dadurch gekennzeichnet, daß die Auswerte-Logik (24) in dem Fall, daß der Zählerstand nach Ablauf des Meßzyklus einen vorgegebenen unteren Grenzwert unterschreitet, während einer vorgegebenen Zeitspanne diejenige Stromquelle (11) aktiviert, welche einen positiven Stromimpuls in das Schleifenfilter (7) einspeist, und daß die Auswerte-Logik in dem Fall, daß der Zählerstand nach Ablauf des Meßzyklus einen vorgegebenen oberen Grenzwert überschreitet, während einer vorgegebenen Zeitspanne diejenige Stromquelle (12) aktiviert, welche einen negativen Stromimpuls in das Schleifenfilter (7) einspeist.

5. Bildwiedergabeanordnung mit einem FM-Demodulator nach einem der Ansprüche 1 bis 4.

6. Verfahren zur Detektion von FM-Tonträgern verschiedener FM-Trägerfrequenzen, welche in einem FM-Bildsignal, vorzugsweise einem ZF-FM-Bildsignal, enthalten sind, mittels eines FM-Demodulators nach einem der Ansprüche 1 bis 5,
dadurch gekennzeichnet, daß eine Steuerung des FM-Demodulators zur Erkennung eines FM-Tonträgers auf einer Soll-Demodulationsfrequenz in der Weise vorgenommen wird, daß in dem Fall, daß die Grenzen-Erkennungsschaltung (13) erkennt, daß die Arbeitsfrequenz der Phasenregelschaltung den vorgegebenen Frequenzbereich um die Soll-Demodulationsfrequenz herum nicht verläßt, ein FM-Tonträger auf der Soll-Demodulationsfrequenz erkannt wird und daß in dem Fall, daß die Grenzen-Erkennungsschaltung (13) erkennt, daß die Arbeitsfrequenz der Phasenregelschaltung den vorgegebenen Frequenzbereich um die Soll-Demodulationsfrequenz herum verläßt, eine andere Soll-Demodulationsfrequenz gewählt wird, für die der Erkennungsvorgang wiederholt wird.

7. Verfahren nach Anspruch 6,
dadurch gekennzeichnet, daß der Erkennungsvorgang nacheinander für alle in Frage kommenden FM-Tonträgerfrequenzen bzw. Soll-Demodulationsfrequenzen vorgenommen wird bis ein FM-Tonträger erkannt wird.

8. Verfahren nach Anspruch 6 oder 7,
dadurch gekennzeichnet, daß eine vorgegebene Anzahl, vorzugsweise zehn, von Meßzyklen ohne Auswertung der Ergebnisse durchfahren wird, bevor der maßgebliche Erkennungsmeßzyklus erfolgt, dessen Ergebnis ausgewertet wird.

9. Verfahren nach einem der Ansprüche 1 bis 8,
dadurch gekennzeichnet, daß eine Erkennung eines Tonträgers nur dann erfolgt, wenn der Meßzyklus eine Erkennung eines Tonträgers ergibt und die Amplitude des Eingangssignals des steuerbaren Verstärkers in einem Soll-Amplitudenbereich liegt.
